# DEMANDE DE BREVET EUROPEEN

(11) **EP 4 750 239 A1**
(43) Date de publication de la demande: **27.05.2026**
(21) Numéro de dépôt: 25216650.9
(22) Date de dépôt: 18.11.2025
(51) Int. Cl.: H05K 7/20

(54) **SYSTÈME DE REFROIDISSEMENT**

(30) Priorité: 21.11.2024 FR 2412749
(71) Demandeur: VALEO SYSTEMES THERMIQUES, 78320 Le Mesnil-Saint-Denis (FR)
(72) Inventeur: LISSNER, Michael, 78320 Le Mesnil-Saint-Denis (FR); LECHAT, Yvan, 95892 Cergy Pontoise (FR)
(74) Mandataire: Valeo Powertrain Systems

(57) **Abrégé**

Un système de refroidissement (100) d'au moins un dispositif électronique, notamment comprenant un serveur (1) de centre de données ou « data center » en anglais, le système de refroidissement comportant :
- un réceptacle (110) configuré pour recevoir le dispositif électronique, ce réceptacle étant notamment étanche pour contenir un fluide diélectrique (30) destiné à immerger, au moins partiellement, le dispositif électronique,
- un échangeur de chaleur (4) de type à plaques, notamment configuré pour définir un fond (112) du réceptacle, et comprenant un circuit (14) pour un fluide caloporteur (35), notamment un réfrigérant, qui est de type diphasique,
- un dispositif de régulation (120) configuré pour réguler le débit de fluide caloporteur en phase liquide entrant dans le circuit de fluide caloporteur de l'échangeur de chaleur (4) en fonction d'une proportion de fluide caloporteur en phase gazeuse à une sortie (5) du circuit de fluide caloporteur.

## Description

La présente invention concerne un système de refroidissement d'au moins un dispositif électronique, notamment comprenant un serveur de centre de données (ou « data center » en anglais).

Il est connu de refroidir des composants électroniques, par exemple appartenant à des serveurs de centre de données (ou « data center » en anglais), en utilisant un fluide diélectrique dans lequel ces composants sont immergés. Ces composants sont, à cet effet, placés dans des boîtiers étanches. Il est connu de refroidir le fluide diélectrique par un système à plaques placé sous le serveur.

La présente invention vise notamment à permettre un refroidissement plus efficace, avec notamment un meilleur échange thermique avec le fluide diélectrique dans lequel les composants électroniques sont immergés.

A cet effet, la présente invention a pour objet un système de refroidissement d'au moins un dispositif électronique, notamment comprenant un serveur de centre de données ou « data center » en anglais, le système de refroidissement comportant :
- un réceptacle configuré pour recevoir le dispositif électronique, ce réceptacle étant notamment étanche pour contenir un fluide diélectrique destiné à immerger, au moins partiellement, le dispositif électronique,
- un échangeur de chaleur de type à plaques, notamment configuré pour définir un fond du réceptacle, et comprenant un circuit pour un fluide caloporteur, notamment un réfrigérant, qui est de type diphasique de sorte qu'en fonctionnement du système de refroidissement, le fluide caloporteur de type diphasique peut changer de phase, entre une phase liquide et une phase gazeuse,
- un dispositif de régulation configuré pour réguler le débit de fluide caloporteur en phase liquide entrant dans le circuit de fluide caloporteur de l'échangeur de chaleur en fonction d'une proportion de fluide caloporteur en phase gazeuse à une sortie du circuit de fluide caloporteur.

Selon l'un des aspects de l'invention, le dispositif de régulation est configuré pour, lorsque la portion en phase gazeuse du fluide caloporteur atteint un seuil prédéterminé à une sortie du circuit, provoquer une augmentation du débit de fluide caloporteur en phase liquide arrivant dans le circuit de fluide caloporteur de sorte à faire remonter le niveau de liquide dans le circuit, et, lorsque la portion en phase gazeuse du fluide caloporteur passe sous le seuil prédéterminé, provoquer une réduction, voire un arrêt, du débit de fluide caloporteur en phase liquide arrivant dans le circuit de fluide caloporteur.

Ainsi, le dispositif de régulation selon l'invention permet, lorsque l'échangeur de chaleur de type à plaques absorbe une grande puissance thermique, avec une grande quantité de vapeur (ou fluide caloporteur en phase gazeuse) qui circule dans le circuit et le niveau de liquide (ou fluide caloporteur en phase liquide) qui diminue dans le circuit, de provoquer une augmentation du débit de fluide caloporteur en phase liquide arrivant dans le circuit de fluide caloporteur de sorte à faire remonter le niveau de liquide dans le circuit. Ceci provoque alors par exemple une fermeture d'une vanne à flotteur à une entrée du circuit. Le système s'autorégule ainsi.

On note encore qu'en utilisant un fluide caloporteur de type diphasique, une perte de charge importante dans le circuit (du fait par exemple d'un virage pour le fluide à l'entrée du circuit) peut être bénéfique pour ajuster la pression d'évaporation dans l'échangeur de chaleur de type à plaques, et ainsi favoriser les échanges thermiques. Avec une perte de charge importante, la pression d'évaporation dans l'échangeur de chaleur de type à plaques est plus basse, donc la température d'évaporation également, augmentant ainsi la différence de température entre le fluide diélectrique de barbotage et le fluide caloporteur (qui est notamment un fluide réfrigérant).

Selon l'un des aspects de l'invention, le dispositif de régulation comporte un organe de restriction de passage qui est mobile de manière à modifier une section de passage de fluide caloporteur en phase liquide en au moins un emplacement du circuit de fluide caloporteur de l'échangeur de chaleur.

Selon l'un des aspects de l'invention, l'organe de restriction de passage présente une forme sensiblement conique. D'autres formes peuvent, bien entendu, être envisagées.

Selon l'un des aspects de l'invention, l'organe de restriction de passage est placé à une entrée du circuit de fluide caloporteur de manière à réguler le débit de fluide caloporteur en phase liquide entrant dans le circuit de fluide caloporteur de l'échangeur de chaleur.

Selon l'un des aspects de l'invention, l'organe de restriction de passage placé à l'entrée du circuit de fluide caloporteur est relié à un flotteur placé à la sortie du circuit.

Selon l'un des aspects de l'invention, le flotteur est configuré pour flotter à la surface du fluide caloporteur en phase liquide et, lorsque le niveau de liquide monte à cette sortie du circuit, l'organe de restriction de passage est déplacé vers une position de restriction de la section de passage de fluide caloporteur en phase liquide en entrée du circuit.

Selon l'un des aspects de l'invention, l'organe de restriction de passage à l'entrée du circuit est relié de manière mécanique au flotteur placé à la sortie du circuit, notamment à l'aide d'un mécanisme comportant un bras de levier ou un mécanisme de type double inverseur.

Selon l'un des aspects de l'invention, le mécanisme entre le flotteur et l'organe de restriction de passage comprend une étanchéité entre l'entrée du circuit et la sortie du circuit.

En positionnant la régulation de débit en entrée du circuit de l'échangeur de chaleur de type à plaques, il est possible avantageusement de simplifier le contrôle du débit de fluide. En effet, il est généralement plus facile de réguler un liquide plutôt qu'un mélange diphasique ou un gaz.

Selon un autre exemple de réalisation de l'invention, l'organe de restriction de passage est placé à la sortie du circuit.

Selon un autre exemple de réalisation de l'invention, l'organe de restriction de passage est réalisé par un flotteur ou vanne à flotteur configuré pour pouvoir flotter sur la phase liquide du fluide caloporteur à la sortie du circuit.

Selon l'un des aspects de l'invention, le flotteur comporte une forme sensiblement en cône.

Selon l'un des aspects de l'invention, le flotteur comporte un ou plusieurs orifices configurés pour permettre le passage de la phase gazeuse du fluide caloporteur.

Selon l'un des aspects de l'invention, le flotteur est configuré pour s'appuyer sur un siège à la sortie du circuit pour créer une restriction de passage.

Selon l'un des aspects de l'invention, lorsque le flotteur est en position de restriction de passage, le flotteur ferme sensiblement le passage de sortie tout en laissant la phase gazeuse du fluide caloporteur s'échapper à travers le ou les orifices sur le flotteur.

Ainsi, en présence de quantité de gaz et donc une quantité moindre de liquide, le flotteur va descendre et libérer une plus grande section de passage pour la phase gazeuse du fluide caloporteur. Ceci va entraîner, à l'entrée du circuit, un appel de phase liquide du fluide caloporteur, et le niveau du liquide peut ainsi remonter dans le circuit et donc à la sortie du circuit. Ceci fait remonter le flotteur en direction de la position de restriction de passage, ce qui limite, voire arrête, le débit de liquide à travers la sortie. L'invention permet ainsi une autorégulation.

Nous avons ainsi, dans ce mode de réalisation, la régulation de débit qui est positionnée en sortie du circuit.

Selon l'un des aspects de l'invention, l'entrée du circuit et la sortie du circuit sont réalisées sur un bloc de connexion fluidique.

L'invention permet ainsi d'avoir l'entrée du circuit et la sortie du circuit, côte à côte. Ceci permet d'avoir, si on le souhaite, une information sur la portion de phase gazeuse à la sortie et d'agir sur l'entrée du circuit pour réguler le débit de liquide.

D'autres caractéristiques, détails et avantages de l'invention ressortiront plus clairement à la lecture de la description qui suit d'une part, et de plusieurs exemples de réalisation donnés à titre indicatif et non limitatif en référence aux dessins schématiques annexés d'autre part, sur lesquels :
[Fig 1] La figure 1 est une représentation schématique, en vue de coupe, d'un système de refroidissement selon l'invention ;
[Fig. 2] La figure 2 est une représentation schématique d'un premier mode de réalisation d'un système de refroidissement selon l'invention ;
[Fig. 3] La figure 3 est une représentation schématique d'une deuxième mode de réalisation d'un système de refroidissement selon l'invention.

Les caractéristiques, variantes et les différentes formes de réalisation de l'invention peuvent être associées les unes avec les autres, selon diverses combinaisons, dans la mesure où elles ne sont pas incompatibles ou exclusives les unes par rapport aux autres. On pourra notamment imaginer des variantes de l'invention ne comprenant qu'une sélection de caractéristiques décrites par la suite de manière isolée des autres caractéristiques décrites, si cette sélection de caractéristiques est suffisante pour conférer un avantage technique et/ou pour différencier l'invention par rapport à l'état de la technique antérieur.

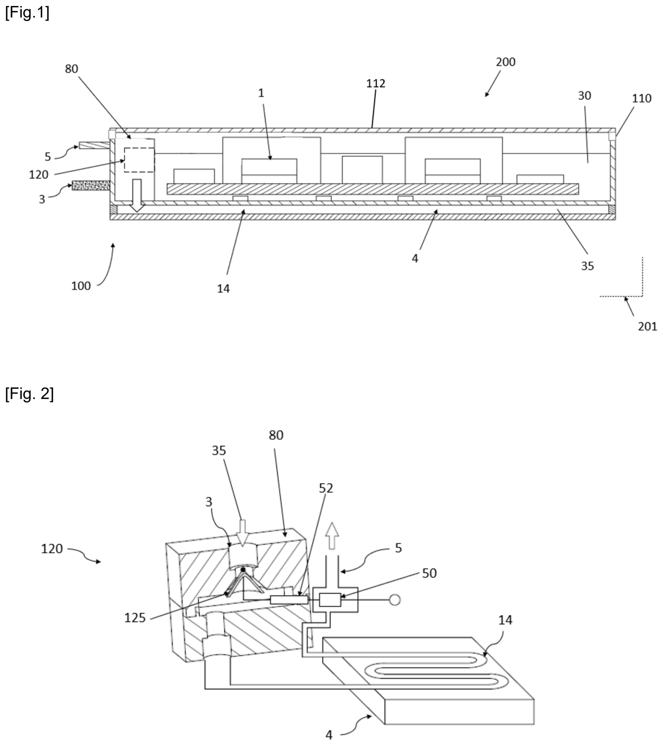

La figure 1 montre un ensemble 200 qui comprend une étagère 201 d'armoire de serveur pour maintenir un système de refroidissement 100 qui reçoit des serveurs 1.

Les serveurs 1 comprennent des processeurs centraux (CPU en anglais) qui sont à refroidir.

Le système de refroidissement 100 est formé d'un réceptacle étanche 110 qui reçoit du fluide diélectrique 30 pour immerger les serveurs 1.

Le système de refroidissement 100 comprend un échangeur de chaleur 4 de type à plaques qui définit un fond 112 du réceptacle 110 étanche et permet de refroidir les serveurs 1. L'échangeur de chaleur 4 comprend un circuit 14 de fluide caloporteur 35 pour refroidir le fluide diélectrique 30 contenu dans le réceptacle 110 étanche.

Le système de refroidissement 100 comprend également un bloc de connexion fluidique 80 qui comporte une entrée 3 de fluide et une sortie 5 de fluide côte à côte. L'entrée 3 et la sortie 5 sont connectées au circuit 14.

Le fluide caloporteur 35 est un fluide de type diphasique qui change de phase, entre une phase liquide et une phase gazeuse lorsque le système de refroidissement 100 est en fonctionnement.

Le système de refroidissement 100 comprend en outre un dispositif de régulation 120 qui régule le débit de fluide caloporteur 35 en phase liquide lorsqu'il entre dans le circuit 14. Cette régulation du débit se fait à l'entrée 3 de fluide du circuit 14 en fonction d'une proportion de fluide caloporteur 35 en phase gazeuse à la sortie 5 du circuit 14 comprise entre 5% et 35%, par exemple 20%.

Lorsque la portion en phase gazeuse du fluide caloporteur 35 atteint un seuil prédéterminé à la sortie 5, compris entre 5% et 35%, par exemple 20%, le dispositif de régulation 120 provoque une augmentation du débit de fluide caloporteur 35 en phase liquide à l'entrée 3 de fluide. Cela permet de faire remonter le niveau de liquide dans le circuit 14.

Lorsque la portion en phase gazeuse du fluide caloporteur 35 passe sous le seuil prédéterminé, le dispositif de régulation 120 provoque une réduction, voire un arrêt, du débit de fluide caloporteur 35 en phase liquide à l'entrée 3 du circuit 14.

La figure 2 montre un premier mode de régulation dans lequel le dispositif de régulation 120 comporte un organe de restriction de passage 125 positionné à l'entrée 3 de fluide du circuit 14. L'organe de restriction de passage 125 présente une forme conique et est mobile de manière à modifier une section de passage de fluide caloporteur 35 en phase liquide à l'entrée 3.

L'organe de restriction de passage 125 est relié à un flotteur 50 placé à la sortie 5 du circuit 14, à l'aide d'un mécanisme 52 qui comprend un bras de levier ou un mécanisme de type double inverseur.

Le flotteur 50 est configuré pour flotter à la surface du fluide caloporteur 35 en phase liquide. Lorsque le niveau de liquide monte à la sortie 5, l'organe de restriction de passage 125 à l'entrée 3, est déplacé vers une position de restriction de la section de passage de fluide caloporteur 35 en phase liquide.

Le mécanisme entre le flotteur 50 et l'organe de restriction de passage 125 comprend une étanchéité entre l'entrée 3 et la sortie 5 du circuit 14.

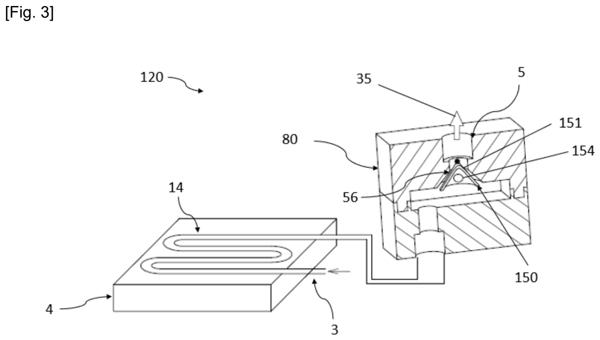

La figure 3 montre un deuxième mode de réalisation dans lequel l'organe de restriction de passage 150 est placé à la sortie 5 du circuit 14.

L'organe de restriction de passage 150 comprend un flotteur 151 configuré pour pouvoir flotter sur la phase liquide du fluide caloporteur 35 à la sortie 5 du circuit 14.

L'organe de restriction de passage 150 et le flotteur 151 peuvent être une même pièce.

Le flotteur 151 comporte un orifice 154 qui permet le passage de la phase gazeuse du fluide caloporteur 35. Le flotteur 151 s'appuie sur un siège 56 à la sortie 5 du circuit 14 pour créer une restriction de passage.

Lorsque le flotteur 151 est en position de restriction de passage, le flotteur 151 ferme le passage de sortie 5 tout en laissant la phase gazeuse du fluide caloporteur 35 de s'échapper à travers l'orifice 154.

Ainsi, en présence de quantité importante de gaz et donc une quantité moindre de liquide, le flotteur 151 descend et libère une plus grande section de passage en sortie 5 pour la phase gazeuse du fluide caloporteur 35. Ceci entraîne, à l'entrée 3, un appel de phase liquide du fluide caloporteur 35. Le niveau du liquide remonte alors dans le circuit 14 et à la sortie 5 de fluide. Ceci fait remonter le flotteur 151 en direction de la position de restriction de passage, ce qui limite, voire arrête, le débit de liquide à travers la sortie 5. Cela permet ainsi une autorégulation du système de refroidissement 100.

## Revendications

1. Système de refroidissement (100) d'au moins un dispositif électronique, notamment comprenant un serveur (1) de centre de données, le système de refroidissement (100) comportant :
- un réceptacle (110) configuré pour recevoir le dispositif électronique, ce réceptacle (110) étant notamment étanche pour contenir un fluide diélectrique (30) destiné à immerger, au moins partiellement, le dispositif électronique,
- un échangeur de chaleur (4) de type à plaques, notamment configuré pour définir un fond (112) du réceptacle (110), et comprenant un circuit (14) pour un fluide caloporteur (35), notamment un réfrigérant, qui est de type diphasique de sorte qu'en fonctionnement du système de refroidissement (100), le fluide caloporteur (35) de type diphasique peut changer de phase, entre une phase liquide et une phase gazeuse,
- un dispositif de régulation (120) configuré pour réguler le débit de fluide caloporteur (35) en phase liquide entrant dans le circuit (14) de fluide caloporteur (35) de l'échangeur de chaleur (4) en fonction d'une proportion de fluide caloporteur (35) en phase gazeuse à une sortie (5) du circuit (14) de fluide caloporteur (35).

2. Système de refroidissement (100) selon la revendication 1, dans lequel le dispositif de régulation (120) est configuré pour, lorsque la portion en phase gazeuse du fluide caloporteur (35) atteint un seuil prédéterminé à la sortie (5) du circuit (14), provoquer une augmentation du débit de fluide caloporteur (35) en phase liquide arrivant dans le circuit (14) de fluide caloporteur (35) de sorte à faire remonter le niveau de liquide dans le circuit (14), et, lorsque la portion en phase gazeuse du fluide caloporteur (35) passe sous le seuil prédéterminé, provoquer une réduction, voire un arrêt, du débit de fluide caloporteur (35) en phase liquide arrivant dans le circuit (14) de fluide caloporteur (35).

3. Système de refroidissement (100) selon l'une des revendications précédentes, dans lequel le dispositif de régulation (120) comporte un organe de restriction de passage (125 ;150) qui est mobile de manière à modifier une section de passage de fluide caloporteur (35) en phase liquide en au moins un emplacement du circuit (14) de fluide caloporteur (35) de l'échangeur de chaleur (4).

4. Système de refroidissement (100) selon la revendication 3, dans lequel l'organe de restriction de passage (125) est placé à une entrée (3) du circuit (14) de fluide caloporteur (35) de manière à réguler le débit de fluide caloporteur (35) en phase liquide entrant dans le circuit (14) de fluide caloporteur (35) de l'échangeur de chaleur (4).

5. Système de refroidissement (100) selon la revendication 4, dans lequel l'organe de restriction de passage (125) est relié à un flotteur (50) placé à la sortie (5) du circuit (14).

6. Système de refroidissement (100) selon la revendication 5, dans lequel l'organe de restriction de passage (125) est relié de manière mécanique au flotteur (50), notamment à l'aide d'un mécanisme comportant un bras de levier (52) ou un mécanisme de type double inverseur.

7. Système de refroidissement (100) selon la revendication 3, dans lequel l'organe de restriction de passage (150) est placé à la sortie (5) du circuit (14).

8. Système de refroidissement (100) selon la revendication 7, dans lequel l'organe de restriction de passage (150) est réalisé par un flotteur (151) ou vanne à flotteur configuré pour pouvoir flotter sur la phase liquide du fluide caloporteur (35) à la sortie (5) du circuit (14).

9. Système de refroidissement (100) selon la revendication 8, dans lequel le flotteur (151) est configuré pour s'appuyer sur un siège (56) à la sortie (5) du circuit (14) pour créer une restriction de passage.

10. Système de refroidissement (100) selon l'une des revendications 8 ou 9, dans lequel le flotteur (151) comporte un ou plusieurs orifices (154) configurés pour permettre le passage de la phase gazeuse du fluide caloporteur (35).
